# EUROPÄISCHE PATENTANMELDUNG

(11) **EP 4 513 215 A1**
(43) Veröffentlichungstag der Anmeldung: **26.02.2025**
(21) Anmeldenummer: 23193108.0
(22) Anmeldetag: 24.08.2023
(51) Int. Cl.: G01R 33/48, G01R 33/383

(54) **ERSTELLUNG VON MESSDATEN MITTELS MAGNETRESONANZ**

(71) Anmelder: Siemens Healthineers AG, 91301 Forchheim (DE)
(72) Erfinder: Grodzki, David, 91058 Erlangen (DE)
(74) Vertreter: Siemens Healthineers Patent Attorneys

(57) **Zusammenfassung**

Durch ein erfindungsgemäßes Erzeugen von MR-Signalen und Aufnehmen von Messdatensätzen bei geschaltetem betragsgemäß konstanten Gradientenfeld, wiederholt mit unterschiedlichen Startrichtungen des Gradientenfelds bei Einstrahlen verschiedener RF-Anregungspulse, ist es möglich, bereits mit gegenüber herkömmlichen Magnetresonanzanlagen günstig und einfach aufgebauten Magnetresonanzanlagen, deren Magneteinheit rotierbar ist und z.B. Permanentmagnete umfasst, MR-Bilder von klinisch akzeptabler Qualität zu erzeugen. In jedem Fall wird bei Durchführen eines erfindungsgemäßen Verfahrens durch die erfindungsgemäße Schaltung der Gradientenfelder eine Geräuschentwicklung durch Ströme in der Hardware der Magnetresonanzanlage vermieden, sodass erfindungsgemäße Aufnahmen von Messdaten besonders leise und somit, z.B. bei Patienten, insbesondere Kindern, als Untersuchungsobjekten, besonders angenehm sind.

## Beschreibung

Die Erfindung betrifft ein Verfahren zur Erstellung von Messdaten eines in einem Messvolumen einer Magnetresonanzanlage befindlichen Untersuchungsobjekts, eine Magnetresonanzanlage sowie ein zugehöriges Computerprogramm und computerlesbares Speichermedium.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Grundsätzlich wird hierzu vereinfacht ausgedrückt das Untersuchungsobjekt in einem Magnetresonanzgerät in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von als Signale messbaren Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld üblicherweise schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), oder auch kurz als Sequenz, bezeichnet. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen FourierTransformation ein zugehöriges MR-Bild rekonstruierbar.

Neben Ortskodierungen für eine zweidimensionale (2D) oder eine dreidimensionale (3D) MR-Bildgebung, kann mittels Verfahren einer sogenannten Projektionsbildgebung (engl.

"(back)projection imaging", "projection acquisition" oder "projection reconstruction") auch ein Projektionsbild des untersuchten Untersuchungsobjektes mit nur einer Ortskodierung in einer Frequenzrichtung erzeugt werden. In einer mehrdimensionalen Projektionsbildgebung erfolgt die Ortskodierung in zwei oder drei Dimensionen weiter allein durch Frequenzkodierung, wobei jedoch die Frequenzkodierrichtung in jedem Kodierschritt variiert wird.

In heutigen Magnetresonanzanlagen wird in aller Regel mit supraleitenden Spulen ein homogenes Grundmagnetfeld B0 erzeugt, die zur Kühlung Helium benötigen und kostenintensiv sind. Aufgrund der hohen Anschaffungs- und Unterhaltskosten sind Magnetresonanzanlagen nicht für alle Regionen und möglichen Anwendungen zugänglich.

Daher werden in den vergangenen Jahren verstärkt andere Konzepte zur MR-Bildgebung und zum Systemdesign untersucht, die deutlich günstiger und nach Möglichkeit bedienungsfreundlicher und unempfindlicher sein sollen. Beispielsweise in dem Artikel von Cooley et al., " Two-Dimensional Imaging in a Lightweight Portable MRI Scanner without Gradient Coils" Magn. Reason. Med. 73, S. 872-883 (2014), oder auch in dem Artikel von Cooley et al., "A portable scanner for magnetic resonance imaging of the brain." Nature Biomed Eng. 5, S. 229-239 (2021), werden Magnetresonanzanlagen untersucht, die Magnetfelder mittels Arrays aus Hallbach-Magneten erzeugen. Permanentmagnete, wie Hallbach-Magnete, haben gegenüber supraleitenden Magneten den Vorteil, dass sie im Allgemeinen deutlich günstiger in der Anschaffung sind und auch ohne jegliche Kühlung auskommen.

Während in dem erstgenannten Artikel von Cooley et al. (2014) für eine MR-Messung die ein homogenes Grundmagnetfeld erzeugende Anordnung der Permanentmagnete um einen zu untersuchenden Patienten gedreht wird, bleibt in dem nächstgenannten Artikel von Cooley et al. (2021) die Anordnung der Hallbach-Magnete statisch und erzeugt auch kein homogenes Grundmagnetfeld sondern ein konstantes Gradientenfeld. Das beschriebene in x-Richtung anliegende Gradientenfeld beträgt 2mT/0.2m = 10 mT/m, was einer in gängigen MR-Messungen verwendeten Gradientenstärke entspricht. Im Unterschied zu gängigen Magnetresonanzanlagen liegt das Gradientenfeld hier immer unveränderlich vor und kann nicht geschaltet werden. Es wird weiter beschrieben, dass mittels zweier Gradientenspulen (in y-Richtung und z-Richtung) weitere Gradientenfelder (einmal in y-Richtung und einmal z-Richtung) erzeugt und dem Gradientenfeld in x-Richtung überlagert werden können. Mit dieser Kombination aus Gradientenspulen und Permanentmagneten konnten Spin-Echo-Bilder erzeugt werden, die allerdings derzeit noch stark mit Artefakten sind. Durch die Notwendigkeit der beschriebenen Gradientenspulen (mit zugehöriger Elektronik, Verstärkern etc.) steigen die Komplexität und die Kosten des Aufbaus, sodass weiterhin nach Lösungen für robuste und Kostengünstige Magnetresonanzanlagen mit zugehöriger Möglichkeit qualitativ ansprechender oder zumindest klinisch auswertbaren Messergebnisse zu erzeugen gesucht wird.

Der Erfindung liegt die Aufgabe zugrunde, eine robuste und kostengünstige Erzeugung von klinisch relevanten Messdaten mittels Magnetresonanztechnik zu ermöglichen.

Die Aufgabe wird gelöst durch ein Verfahren zur Erstellung von Messdaten eines in einem Messvolumen einer Magnetresonanzanlage befindlichen Untersuchungsobjekts gemäß Anspruch 1, eine Magnetresonanzanlage gemäß Anspruch 11, ein Computerprogramm gemäß Anspruch 15, sowie einen elektronisch lesbaren Datenträger gemäß Anspruch 16.

Ein erfindungsgemäßes Verfahren zur Erstellung von Messdaten eines in einem Messvolumen einer Magnetresonanzanlage befindlichen Untersuchungsobjekts umfasst die Schritte:
a) Anlegen eines Gradientenfelds mit konstantem Wert und einer ersten Startrichtung in dem Messvolumen mittels der Magnetresonanzanlage,
b) Einstrahlen eines RF-Anregungspulses in das Messvolumen,
c) nach einer Schaltzeit Tₛ, welche insbesondere eine Dauer von kleiner als 20 Mikrosekunden, bevorzugt kleiner als 10 Mikrosekunden, besonders bevorzugt kleiner als 5 Mikrosekunden, hat Aufnehmen von durch den RF-Anregungspuls erzeugten MR-Signalen als Messdaten entlang der durch das angelegte Gradientenfeld vorgegebenen k-Raumtrajektorie und Speichern dieser Messdaten in einem ersten Messdatensatz,
d) Aufnehmen zumindest eines weiteren Messdatensatzes durch Wiederholen der Schritte a) bis c), wobei das in einer Wiederholung angelegte Gradientenfeld bei Einstrahlen des RF-Anregungspulses in Schritt b) jeweils eine weitere von der ersten Startrichtung verschiedene Startrichtung aufweist,
e) Erstellen eines MR-Bildes des Untersuchungsobjektes aus den aufgenommenen Messdatensätzen.

Durch das erfindungsgemäße Erzeugen von MR-Signalen und Aufnehmen von Messdatensätzen bei geschaltetem betragsgemäß konstanten Gradientenfeld, wiederholt mit unterschiedlichen Startrichtungen des Gradientenfelds bei Einstrahlen verschiedener RF-Anregungspulse, ist es möglich, bereits mit gegenüber herkömmlichen Magnetresonanzanlagen günstig und einfach aufgebauten Magnetresonanzanlagen, deren Magneteinheit rotierbar ist und z.B. Permanentmagnete umfasst, MR-Bilder von klinisch akzeptabler Qualität zu erzeugen. In jedem Fall wird bei Durchführen eines erfindungsgemäßen Verfahrens durch die erfindungsgemäße Schaltung der Gradientenfelder eine Geräuschentwicklung durch Ströme in der Hardware der Magnetresonanzanlage vermieden, sodass erfindungsgemäße Aufnahmen von Messdaten besonders leise und somit, z.B. bei Patienten, insbesondere Kindern, als Untersuchungsobjekten, besonders angenehm sind.

Eine erfindungsgemäße Magnetresonanzanlage umfasst eine Magneteinheit, eine Hochfrequenzeinheit und eine zur Durchführung eines erfindungsgemäßen Verfahrens ausgebildete Steuereinrichtung mit einer Gradientenrotationseinheit.

Ein erfindungsgemäßes Computerprogramm implementiert ein erfindungsgemäßes Verfahren auf einer Steuereinrichtung, wenn es auf der Steuereinrichtung ausgeführt wird. Beispielsweise umfasst das Computerprogramm Befehle, die bei der Ausführung des Programms durch eine Steuereinrichtung, z.B. eine Steuereinrichtung einer Magnetresonanzanlage, diese Steuereinrichtung veranlassen, ein erfindungsgemäßes Verfahren auszuführen. Die Steuereinrichtung kann in Form eines Computers gestaltet sein.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in einer Recheneinheit des Rechensystems ausgeführt wird.

Ein erfindungsgemäßes computerlesbares Speichermedium umfasst Befehle, die bei der Ausführung durch eine Steuereinrichtung, z.B. eine Steuereinrichtung einer Magnetresonanzanlage, diese veranlassen, ein erfindungsgemäßes Verfahren auszuführen.

Das computerlesbare Speichermedium kann als elektronisch lesbarer Datenträger ausgestaltet sein, welcher darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
Fig. 1 ein schematisches Ablaufdiagram eines erfindungsgemäßen Verfahrens,
Fig. 2 ein schematisch dargestellter Teil von Pulssequenzschemata zur Erfassung von Messdaten mit erfindungsgemäßen Gradientenfeldern,
Figs. 3-5 schematisch dargestellte beispielhafte k-Raumtrajektorien entlang derer Messdaten erfindungsgemäß aufgenommen werden können,
Fig. 6 eine schematisch dargestellte erfindungsgemäße Magnetresonanzanlage.

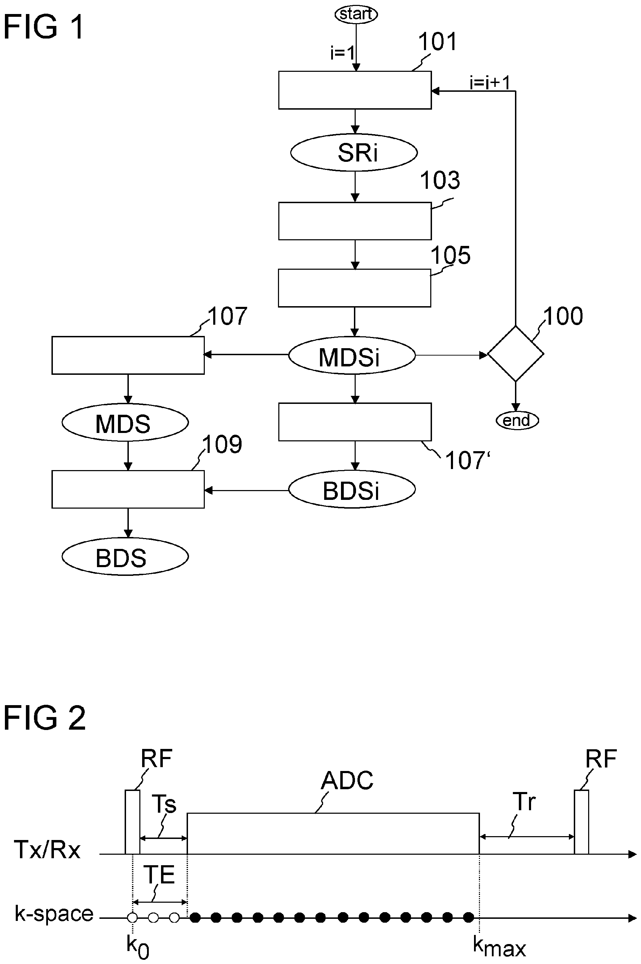

Figur 1 ist ein schematisches Ablaufdiagramm eines erfindungsgemäßen Verfahrens zur Erstellung von Messdaten eines in einem Messvolumen einer Magnetresonanzanlage befindlichen Untersuchungsobjekts.

Es wird ein Gradientenfeld mit konstantem Wert und einer ersten Startrichtung SRi (i=1) in dem Messvolumen mittels der Magnetresonanzanlage angelegt (Block 101).

Ein RF-Anregungspuls RF wird in das Messvolumen eingestrahlt, wodurch MR-Signale ausgelöst werden (Block 103). Ein derartiger RF-Anregungspuls kann beispielsweise ein kurzer, rechteckförmiger RF-Puls, auch Hardpuls genannt, sein, der räumlich nicht-selektiv ist.

Nach einer Schaltzeit Tₛ nach dem RF-Anregungspuls werden durch den RF-Anregungspuls erzeugte MR-Signale als Messdaten entlang der durch das angelegte Gradientenfeld vorgegebenen k-Raumtrajektorie aufgenommen und in einem ersten Messdatensatz MDSi (i=1) gespeichert. Die Schaltzeit Tₛ ist vorteilhaft die durch die Hardware der Magnetresonanzanlage bedingt kürzest mögliche Schaltzeit, die für ein Umschalten von einem Sendebetrieb zum Einstrahlen des RF-Anregungspulses auf einen Empfangsbetrieb zum Aufnehmen der Messdaten mindestens aufgewendet werden muss. Zusätzlich oder alternativ hat die Schaltzeit Tₛ insbesondere eine Dauer von kleiner als 20 Mikrosekunden, bevorzugt kleiner als 10 Mikrosekunden, besonders bevorzugt kleiner als 5 Mikrosekunden.

Es wird zumindest ein weiterer Messdatensatz MDSi (i>1) aufgenommen, indem die Blöcke 101 bis 105 wiederholt werden, wobei für das in einer Wiederholung angelegte Gradientenfeld in Block 101 eine weitere von der ersten Startrichtung SRi (i=1) verschiedene Startrichtung SRi (i>1) bestimmt ist, die das Gradientenfeld bei Einstrahlen des RF-Anregungspulses in Block 103 aufweist. Ob bereits alle vorgesehenen Wiederholungen mit ihren jeweiligen Startrichtungen SRi durchgeführt wurden, wird in der Abfrage 100 überprüft.

Die erste und alle weiteren Startrichtungen können beispielsweise durch ein Rotieren einer Magneteinheit der Magnetresonanzanlage bis ein der gewünschten Startrichtung entsprechender Rotationswinkel der Magneteinheit erreicht ist, eingestellt werden.

Es kann eine feste Anzahl an Wiederholungen vorgegeben sein. Beispielsweise können so lange weitere Messdatensätze mit jeweiligen weiteren Startrichtungen aufgenommen werden, bis eine gewünschte Abdeckung des k-Raums durch alle k-Raumtrajektorien, entlang derer Messdatensätze MDSi aufgenommen wurden, erreicht ist. Es ist denkbar, dass insgesamt über hundert, z.B. zwischen 180 und 500 oder mehr, Messdatensätze MDSi mit unterschiedlichen Startrichtungen SRi der jeweiligen Gradientenfelder aufgenommen werden. Durch eine erhöhte Anzahl an Wiederholungen wird das erreichbare Signal-RauschVerhältnis ebenfalls erhöht und es kann eine dichtere Abdeckung des k-Raums erreicht werden, da mehr verschiedene Startrichtungen SRi eingesetzt werden.

Sind alle gewünschten Wiederholungen durchgeführt, endet die Aufnahme von Messdaten ("end"), wenn nicht, wird der Zähler der Wiederholungen i um Eins erhöht ("i=i+1") und eine Wiederholung gestartet.

Aus den aufgenommenen Messdatensätzen MDSi wird ein MR-Bild BDS des Untersuchungsobjektes erstellt, dass gespeichert und/oder weiterverarbeitet werden kann (Block 109). Das Erstellen des MR-Bildes BDS kann beispielsweise Techniken wie Regridding und/oder gefilterte Rückprojektion (engl. "filtered backprojection") umfassen. Durch Regridding können auf nicht-kartesischen k-Raumpunkten aufgenommene Messdaten auf ein kartesisches k-Raumgitter überführt werden, wodurch dann eine einfachere Fouriertransformation möglich ist.

Dabei können die aufgenommenen Messdatensätze MDSi zu einem gemeinsamen Messdatensatz MDS zusammengefügt werden (Block 107), aus welchem das MR-Bild BDS erstellt wird.

Es ist auch denkbar, aus den aufgenommenen Messdatensätzen MDSi jeweils Bilddaten BDSi zu erzeugen (Block 107') und das MR-Bild BDS aus den jeweiligen erzeugten Bilddaten BDSi zu erstellen. Hierbei kann insbesondere, wenn keine weiteren Kodierungsfelder angelegt wurden, und die Bilddaten BDSi somit jeweils 2D Proketionsbilder sind, vergleichbar zu einer Computertomographie(CT)-Bildrekonstruktion vorgegangen werden.

Figur 2 zeigt erklärend schematisch einen Teil eines derartigen Pulssequenzschemas wie er für das erfindungsgemäße Verfahren verwendet werden kann, wobei in der Zeile "Tx/Rx" die eingestrahlten RF-Anregungspulse RF und die Auslesezeitfenster ADC, während derer die Aufnahme der Messdaten stattfindet, dargestellt sind. In der unteren Zeile "k-space" sind die zugehörigen entlang der durch das angelegte Gradientenfeld vorgegebenen k-Raumtrajektorie zur Aufnahme der Messdaten abgetasteten k-Raumpunkte dargestellt. Hierbei sind gemessene k-Raumpunkte als schwarze Punkte und vor dem Beginn des Auslesezeitfensters liegende, und daher nicht-ausgelesene k-Raumpunkte als "leere" Punkte gezeigt. Dass k-Raumpunkte nicht ausgelesen werden, bedingt sich dadurch, dass, wie beschrieben, bereits vor dem Einstrahlen des RF-Anregungspulses RF ein konstantes Gradientenfeld angelegt ist (nicht dargestellt, da zumindest vom Betrag her stets konstant). Dadurch wäre der zentrale k-Raumpunkt (k=0) zeitgleich mit dem Einstrahlen des RF-Anregungspulses RF zu messen, was technisch nicht möglich ist. Erst nach einer Schaltzeit Tₛ nach dem Ende des RF-Anregungspulses RF kann in dem Auslesezeitfenster ADS mit der Aufnahme der Messdaten begonnen werden, wodurch sich weiterhin eine (kürzeste) Echozeit TE ergibt.

Die nicht-abgetasteten ("leeren") k-Raumpunte können mittels algebraischer Rekonstruktion berechnet werden, wie es z.B. in dem Artikel von Weiger et al., "High-Bandwidth ZTE Imaging with sub-Millisecond TR", Proc. Intl. Soc. Mag. Reson. Med. 21, S. 761 (2013) beschrieben ist. Je kleiner die Dauer der Schaltzeit Ts ist, desto weniger k-Raumpunkte werden "verpasst" bis die Aufnahme der Messdaten mit dem Beginn des Auslesezeitfensters ADC beginnt. Um die algebraische Rekonstruktion möglichst aufwandsarm und schnell, dabei aber auch möglichst genau, zu halten, sollten möglichst wenige k-Raumpunkte nicht ausgelesen werden. Beispielsweise weniger als drei pro abgetasteter k-Raumtrajektorie. Der letzte in dem Auslesezeitfenster ADC ausgelesene k-Raumpunkt kₘₐₓ hat unter den ausgelesenen k-Raumpunkten den maximalen Abstand von k-Raumzentrum. Die Dauer des Auslesezeitfensters (Akquisitionsdauer) ist gegeben durch die Stärke des anliegenden Gradientenfelds und der geforderten Auflösung bzw. des gewünschten Bildbereichs (engl. "field of view", FOV) oder Matrix des aus den Messdaten zu erstellenden (Projektions)Bildes.

Während oder bis Ende einer Rotationszeit Tr, die kurz gehalten sein kann, kann eine gewünschte weitere Startrichtung des vom Betrag her stets konstanten angelegten Gradientenfelds eingestellt werden, die bei Einstrahlen des nachfolgenden, weiteren RF-Anregungspulses RF erreicht sein soll.

Erfolgt außer durch das angelegte Gradientenfeld mit konstanter Stärke und während einem Auslesezeitfenster ADS fester Richtung keine weitere Kodierung der Messdatensätze MDSi, werden also keine zusätzlichen Gradientenfelder angelegt, und erfolgt somit insbesondere auch keine Schichtkodierung, entsprechen die aufgenommenen Messdatensätze MDSi jeweils einem Messdatensatz für eine 2D-Projektionsbildgebung, d.h. es kann quasi ein als röntgenartig bezeichenbares "Durchleutbild" mit einer der Startrichtung SRi entsprechenden Durchleuchtrichtung aus einem derartigen Messdatensatz MDSi erzeugt werden.

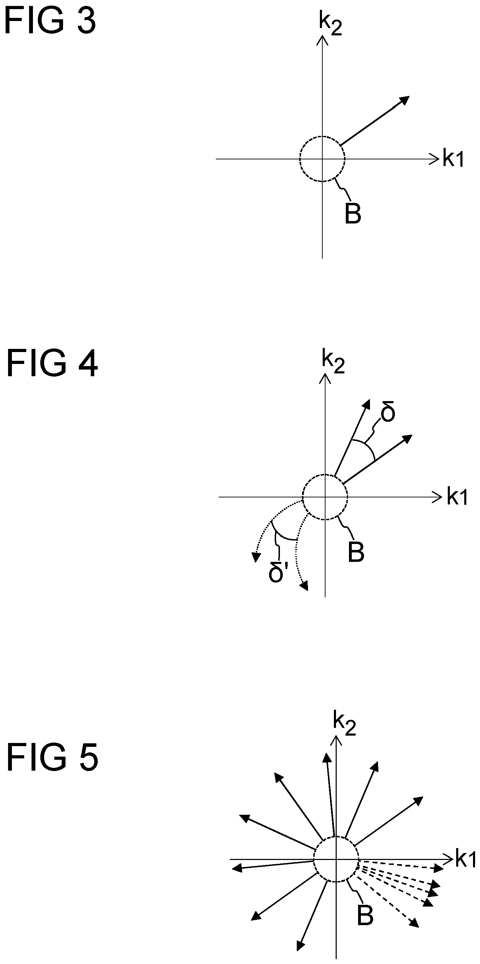

Zur weiteren Erläuterung sind in den Figuren 3 bis 5 beispielhafte k-Raumtrajektorien entlang derer Messdaten erfindungsgemäß aufgenommen werden können dargestellt.

Figur 3 zeigt ein einfaches Beispiel einer in einer k1-k2-Ebene des k-Raums als durchgehender Pfeil dargestellten von innen nach außen verlaufenden radialen k-Raumtrajektorie (Speiche), wie sie sich durch Einstrahlen eines RF-Anregungspulses bei anliegendem konstanten Gradientenfeld und nachfolgendem Aufnehmen von Messdaten ergibt. Die Richtung, in welche die k-Raumtrajektorie weist, entspricht der Startrichtung, welche hier über die gesamte Aufnahme der Messdaten beibehalten wird (was aus dem geradlinigen Verlauf der k-Raumtrajektorie ersichtlich ist). Wie bereits mit Bezug auf Figur 2 diskutiert, ergibt sich um das k-Raumzentrum herum ein Bereich B, in welchem keine Messdaten aufgenommen werden. Der Radius des Bereichs B hängt somit von der Schaltzeit Tₛ ab. Erfolgt wie bereits beschrieben keine weitere Kodierung, handelt es sich um einen 2D k-Raum einer Projektionsmessung.

Sollte eine weitere Kodierung gewünscht sein, sind entsprechende Gradientenspulen nötig, um weitere Gradientenfelder anlegen zu können. Für eine 3D Messung wäre eine derartige weitere Kodierung in zumindest eine weitere möglichst parallel zur Rotationsachse des konstanten Gradientenfelds orientierte Richtung (Schichtrichtung) erforderlich, da auch in Schichtrichtung ein Gradient erzeugt werden müsste. Für die Kodierung in diese (dritte) Richtung müsste sich dieser Gradient ändern können, entweder indem sich der Magnet auch in 3D um das Untersuchungsobjekt dreht (bei Ganzkörper ausgeschlossen, für kleinere Objekte denkbar) oder zumindest eine weitere Gradientenachse besitzen, was die Komplexität und damit die Kosten der hierfür erforderlichen Magnetresonanzanlage erhöhen würde.

In den Figuren 4 und 5 sind gleiche Bezugszeichen und Darstellungen für Bedeutungsgleiches verwendet.

In Figur 4 ist beispielhaft zusätzlich zu der bereits in Figur 3 gezeigten Speiche eine weitere, einer Wiederholung mit einer weiteren Startrichtung entsprechende als durchgehender Pfeil dargestellte k-Raumtrajektorie, die sich um ein Winkelinkrement δ von der vorherigen Speiche unterscheidet, dargestellt.

In einem unteren Quadranten der gezeigten k1-k2-Ebene des k-Raums sind als alternative Beispiele gebogene k-Raumtrajektorien als gepunktete Pfeile gezeigt. Derartige k-Raumtrajektorien können sich ergeben, wenn das angelegte Gradientenfeld auch während der Aufnahme der Messdaten weiter kontinuierlich rotiert wird, wobei die Rotationsgeschwindigkeit die Krümmung vorgibt. Die beiden gebogenen k-Raumtrajektorien können in zwei Wiederholungen mit Startrichtungen, welche sich um ein Winkelinkrement δ' unterscheiden abgetastet werden. Durch eine derartige kontinuierliche Drehung des vom Betrag her konstanten Gradientenfelds kann die die Rotationszeit Tr und damit die Repetitionszeit TR die zwischen zwei aufeinanderfolgenden RF-Anregungspulsen vergeht klein gehalten werden. Dabei kann darauf geachtet werden, dass die Repetitionszeit (meist 3-5ms) so klein gegenüber der Drehgeschwindigkeit gehalten wird, dass nach einer vollständigen Umdrehung alle gewünschten Wiederholungen durchgeführt sind. Derartige k-Raumtrajektorien in Form von gebogenen Speichen können im k-Raum auf ein kartesisches Gitter gegriddet werden, wobei eine genaue Kenntnis der Drehgeschwindigkeit und möglichst hohe Genauigkeit wichtig ist, um Artefakte zu vermeiden.

In Figur 5 sind als durchgehende Pfeile weitere k-Raumtrajektorien gezeigt, wie sie sich durch Wiederholungen mit weiteren Startrichtungen, die sich um Vielfache eines festen Winkelinkrements von der ersten Startrichtung (siehe z.B. Figur 3) unterscheiden. Werden weitere Startrichtungen gewählt, die sich um Vielfache eines festen Winkelinkrements von der ersten Startrichtung unterscheiden, kann eine gleichmäßige Abdeckung des k-Raums erreicht werden, insbesondere, wenn als Winkelinkrement ein Teiler von 360° verwendet wird. Durch ein stetiges Verändern der Startrichtung in eine Richtung und Vermeidung von "hin und her" kann Rotationszeit gespart werden.

So kann beispielsweise erreicht werden, dass die erste und die weiteren Startrichtungen in gewünschten Winkelbereichen einer kompletten Drehung, insbesondere in dem Winkelbereich einer kompletten Drehung (360°) in einer Ebene möglichst gleichmäßig verteilt liegen.

Dabei kann das Winkelinkrement in Abhängigkeit einer gewünschten Auflösung des MR-Bildes gewählt werden. Insbesondere kann das Winkelinkrement einen Wert zwischen 0,1° und 30°, bevorzugt zwischen 0,5° und 5°, besonders bevorzugt zwischen 1° und 2°, haben. Für eine Auflösung von 1mm eines aus derartig aufgenommenen Messdaten erstellten Projektionsbildes können beispielsweise 200 bis 500 Wiederholungen mit gleichmäßig auf eine volle Drehung von 360°verteilten Startrichtungen durchgeführt werden.

Alternativ sind auch beliebige oder einer gewünschten Dichte in einem gewünschten Winkelbereich einer kompletten Drehung in einer Ebene entsprechende Winkelinkremente zwischen den verschiedenen Startrichtungen der durchzuführenden Wiederholungen denkbar.

Dazu ist in Figur 5 mit gestrichelten Pfeilen eine Ausführungsform angedeutet, bei der die verschiedenen Wiederholungen zugehörigen k-Raumtrajektorien durch zugehörige ungleichmäßig variierende Startrichtungen einen Winkelbereich (hier im unteren linken Quadranten) mit variierender Dichte abdecken.

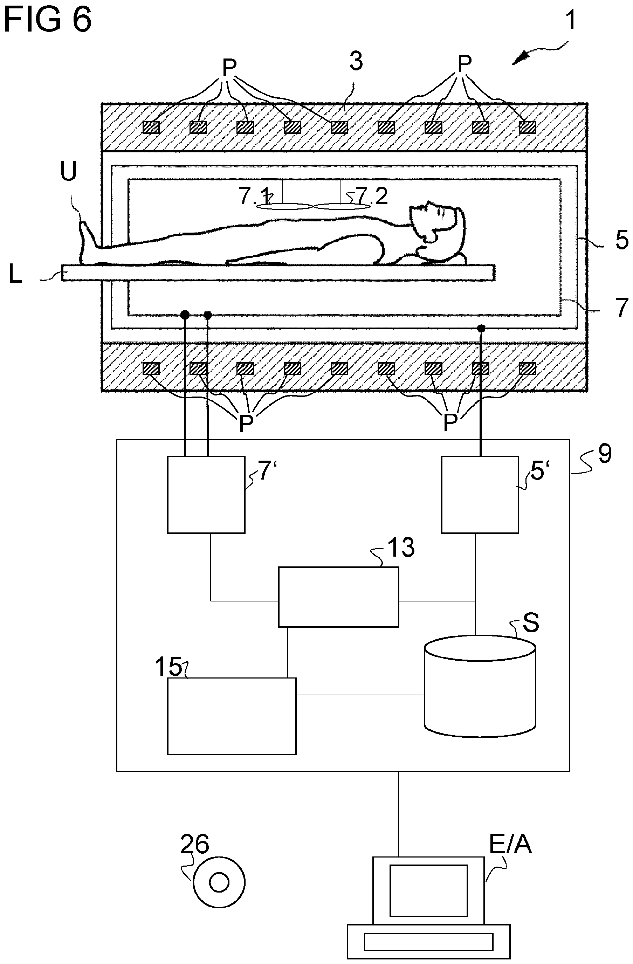

Figur 6 stellt schematisch eine erfindungsgemäße Magnetresonanzanlage 1 dar. Diese umfasst eine Magneteinheit 3 zur Erzeugung des Grundmagnetfeldes, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

Die Magneteinheit 3 kann Permanentmagnete P, insbesondere Hallbach-Magnete, umfassen.

Dabei können die Permanentmagnete P derart angeordnet sein, dass durch die Magneteinheit 3 ein Magnetfeld mit konstantem Gradientenfeld erzeugt wird, welches sich möglichst linear in einer Richtung im Raum ändert. Eine derartige Anordnung von Permanentmagneten P ist beispielsweise in dem oben genannten Artikel von Cooley et al. (2021) beschrieben.

Grundsätzlich ist es denkbar, dass die Magnetresonanzanlage 1 weiterhin eine Gradienteneinheit 5 zur Erzeugung der Gradientenfelder umfasst. Dies ist jedoch nicht zwingend erforderlich, insbesondere, wenn das durch die Magneteinheit 3 erzeugte Magnetfeld bereits einen Gradienten aufweist.

Die Magneteinheit 3 ist insbesondere um ein Messvolumen, in welchem sich das Untersuchungsobjekt während der Aufnahme der Messdaten befindet, der Magnetresonanzanlage 1 rotierbar. Die Rotation der Magneteinheit 3 kann hierbei durch eine z.B. von der Steuereinrichtung 9 umfasste Gradientenrotationseinheit 15 gesteuert werden. Die Gradientenrotationseinheit 15 erlaubt insbesondere ein Einstellen von erfindungsgemäßen Startrichtungen und ggf. eine kontinuierliche Rotation der Magneteinheit 3 mit einer wählbaren Drehgeschwindigkeit.

In der Figur 6 sind diese Teileinheiten der Magnetresonanzanlage 1 nur grob schematisch dargestellt. Insbesondere kann die Hochfrequenzeinheit 7 auch aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden.

Die Steuereinrichtung 9 dient der Steuerung der Magnetresonanzanlage 1 und kann die Hochfrequenzeinheit 7 mittels einer Hochfrequenz-Sende-/Empfangs-Steuerung 7' und ggf. die Gradienteneinheit 5 mittels einer Gradientensteuerung 5' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können. Die Steuereinrichtung 9 ist insgesamt dazu ausgebildet, ein erfindungsgemäßes Verfahren durchzuführen.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogramms vorliegen, welches Befehle umfasst, die das beschriebene Verfahren auf einer Steuereinrichtung 9 ausführen. Ebenso kann ein computerlesbares Speichermedium vorliegen, welches Befehle umfasst, die bei der Ausführung durch eine Steuereinrichtung 9 einer Magnetresonanzanlage 1 diese veranlassen, das beschriebene Verfahren auszuführen.

*Unabhängig vom grammatikalischen Geschlecht eines bestimmten Begriffes sind Personen mit männlicher, weiblicher oder anderer Geschlechteridentität mit umfasst.*

## Patentansprüche

1. Verfahren zur Erstellung von Messdaten eines in einem Messvolumen einer Magnetresonanzanlage befindlichen Untersuchungsobjekts (U) umfassend die Schritte:
a) Anlegen eines Gradientenfelds mit konstantem Wert und einer ersten Startrichtung (SRi, i=1) in dem Messvolumen mittels der Magnetresonanzanlage (1),
b) Einstrahlen eines RF-Anregungspulses (RF) in das Messvolumen,
c) nach einer Schaltzeit Tₛ, welche insbesondere die durch die Hardware der Magnetresonanzanlage (1) bedingt kürzest mögliche Schaltzeit, die für ein Umschalten von einem Sendebetrieb zum Einstrahlen des RF-Anregungspulses (RF) auf einen Empfangsbetrieb zum Aufnehmen der Messdaten mindestens aufgewendet werden muss, ist und/oder eine Dauer von kleiner als 20 Mikrosekunden, bevorzugt kleiner als 10 Mikrosekunden, besonders bevorzugt kleiner als 5 Mikrosekunden, hat Aufnehmen von durch den RF-Anregungspuls (RF) erzeugten MR-Signalen als Messdaten entlang der durch das angelegte Gradientenfeld vorgegebenen k-Raumtrajektorie und Speichern dieser Messdaten in einem ersten Messdatensatz (MDSi, i=1),
d) Aufnehmen zumindest eines weiteren Messdatensatzes (MDSi, i>1) durch Wiederholen der Schritte a) bis c), wobei das in einer Wiederholung angelegte Gradientenfeld bei Einstrahlen des RF-Anregungspulses (RF) in Schritt b) jeweils eine weitere von der ersten Startrichtung (SRi, i=1) verschiedene Startrichtung (SRi, i>1) aufweist,
e) Erstellen eines MR-Bildes (BDS) des Untersuchungsobjektes (U) aus den aufgenommenen Messdatensätzen (MDSi).

2. Verfahren nach Anspruch 1, wobei die aufgenommenen Messdatensätze (MDSi) zu einem gemeinsamen Messdatensatz (MDS) zusammengefügt werden und das MR-Bild (BDS) aus dem gemeinsamen Messdatensatz (MDS) erstellt wird.

3. Verfahren nach Anspruch 1, wobei aus den aufgenommenen Messdatensätzen (MDSi) jeweils Bilddaten (BDSi) erzeugt werden und das MR-Bild (BDS) aus den jeweiligen Bilddaten (BDSi) erstellt wird.

4. Verfahren nach einem der vorhergehenden Ansprüche, wobei so lange weitere Messdatensätze (MDSi, i>1) mit jeweiligen weiteren Startrichtungen (SRi, i>1) aufgenommen werden, bis eine gewünschte Abdeckung des k-Raums durch alle k-Raumtrajektorien, entlang derer Messdatensätze (MDSi) aufgenommen wurden, erreicht ist.

5. Verfahren nach einem der vorhergehenden Ansprüche, wobei weitere Startrichtungen (SRi, i>1) sich um Vielfache eines festen Winkelinkrements (δ) von der ersten Startrichtung (SRi, i=1) unterscheiden.

6. Verfahren nach Anspruch 5, wobei das Winkelinkrement (δ) in Abhängigkeit einer gewünschten Auflösung des MR-Bildes (BDS) gewählt wird, und insbesondere einen Wert zwischen 0,1° und 30°, bevorzugt zwischen 0,5° und 5°, besonders bevorzugt zwischen 1° und 2°, hat.

7. Verfahren nach einem der vorhergehenden Ansprüche, wobei die erste und die weiteren Startrichtungen (SRi) in Winkelbereichen einer kompletten Drehung in einer Ebene möglichst gleichmäßig oder mit vorgegebenen unterschiedlichen Dichten liegen.

8. Verfahren nach einem der vorhergehenden Ansprüche, wobei außer durch die jeweils angelegten Gradientenfelder keine weitere Kodierung der Messdatensätze (MDSi) erfolgt.

9. Verfahren nach einem der vorhergehenden Ansprüche, wobei insgesamt über hundert, z.B. zwischen 180 und 500 oder mehr, Messdatensätze (MDSi) mit unterschiedlichen Startrichtungen (SRi) der jeweiligen Gradientenfelder aufgenommen werden.

10. Verfahren nach einem der vorhergehenden Ansprüche, wobei die erste und alle weiteren Startrichtungen (SRi) durch Rotieren einer Magneteinheit (3) der Magnetresonanzanlage (1) bis ein der gewünschten Startrichtung (SRi) entsprechender Rotationswinkel erreicht ist, eingestellt werden.

11. Magnetresonanzanlage (1) umfassend, eine Magneteinheit (3), eine Hochfrequenzeinheit (7) und eine Steuereinrichtung (9) mit einer Hochfrequenz-Sende-/Empfangs-Steuerung (7') und mit einer Gradientenrotationseinheit (15), wobei die Steuereinrichtung (9) dazu ausgebildet ist, ein Verfahren nach einem der Ansprüche 1 bis 10 auf der Magnetresonanzanlage (1) auszuführen.

12. Magnetresonanzanlage nach Anspruch 11, wobei die Magneteinheit (3) Permanentmagnete (P), insbesondere Hallbach-Magnete, umfasst.

13. Magnetresonanzanlage nach Anspruch 12, wobei die Permanentmagnete (P) derart angeordnet sind, dass durch die Magneteinheit (3) ein Magnetfeld mit konstantem Gradienten erzeugt wird.

14. Magnetresonanzanlage nach einem der Ansprüche 11 bis 13, wobei die Magneteinheit (3) um ein Messvolumen der Magnetresonanzanlage (1) rotierbar ist und die Rotation der Magneteinheit (3) durch die Gradientenrotationseinheit (15) gesteuert wird.

15. Computerprogramm, umfassend Befehle, die bei der Ausführung des Programms durch eine Steuereinrichtung (9) einer Magnetresonanzanlage (1) diese veranlassen, das Verfahren nach einem der Ansprüche 1 bis 10 auszuführen.

16. Computerlesbares Speichermedium, umfassend Befehle, die bei der Ausführung durch eine Steuereinrichtung (9) einer Magnetresonanzanlage (1) diese veranlassen, das Verfahren nach einem der Ansprüche 1 bis 10 auszuführen.
